Europäisches Patentamt

European Patent Office

Office européen des brevets

(19)

(11) EP 0 890 979 A1

(12) **DEMANDE DE BREVET EUROPEEN**

(43) Date de publication:
13.01.1999 Bulletin 1999/02

(51) Int. Cl.$^6$: **H01L 21/3205**, H01L 21/285, H01L 21/321, C23C 14/58

(21) Numéro de dépôt: 97111826.0

(22) Date de dépôt: 11.07.1997

(84) Etats contractants désignés:
AT BE CH DE DK ES FI FR GB GR IE IT LI LU MC NL PT SE

(71) Demandeur:
EM Microelectronic-Marin SA
2074 Marin (CH)

(72) Inventeurs:
• Schönbächler, Edgar
2087 Cornaux (CH)

• Lecohier, Baudouin
2022 Bevaix (CH)

(74) Mandataire:
Patry, Didier Marcel Pierre et al
I C B,
Ingénieurs Conseils en Brevets S.A.
Rue des Sors 7
2074 Marin (CH)

(54) **Méthode d'optimisation de procédés de dépôt et de gravure, en fonction de la structure d'une couche polycristalline à déposer et à graver**

(57) La présente invention concerne une méthode d'optimisation de procédés de dépôt et de gravure comprenant des étapes consistant à déposer une couche polycristalline composée d'au moins deux espèces chimiques, cette couche étant constituée de grains et de joints de grains, et graver la couche polycristalline par un agent réactif destiné à réagir avec l'une des deux espèces chimiques. Cette méthode est caractérisée en ce qu'elle consiste à déterminer les paramètres de dépôt susceptibles de provoquer la formation d'une couche polycristalline ayant la densité de joints de grain liée à une valeur optimale de la vitesse de gravure, et prendre en compte ces paramètres lors de la mise en oeuvre de ces procédés. Cette méthode définit en outre un paramètre de structure représentant la densité de joints de grain de la couche polycristalline, ce paramètre étant égal à la longueur totale de joint de grain par unité de surface.

Fig. 4

**Description**

La présente invention concerne le domaine de la fabrication de circuits intégrés et, plus particulièrement, des méthodes d'optimisation de procédés de dépôt et de gravure mis en oeuvre lors de la fabrication de circuits intégrés.

Au cours d'une filière classique de fabrication de circuits intégrés, on forme un empilement de couches minces sur un support semi-conducteur ou substrat.

Pour l'essentiel, on peut distinguer deux types de technique de dépôt pour former une couche mince sur un substrat. Les techniques dites "physiques" sont basées sur une croissance par condensation sur un substrat de jets de molécules ou d'atomes (neutres ou ionisés), ces jets de particules étant obtenus par évaporation ou par pulvérisation d'une source. On parle ainsi de dépôt par évaporation sous vide, par pulvérisation cathodique, ou par épitaxie par jet moléculaire. Par ailleurs, les techniques dites "chimiques" sont basées sur une réaction chimique à la surface du substrat, ou de la couche en cours de formation. Cette réaction libère des espèces chimiques qui vont intervenir pour assurer ou poursuivre la croissance de la couche. On parle ainsi de dépôt par épitaxie en phase liquide ou en phase vapeur.

Dans la suite de la filière, les couches polycristallines ainsi formées sont gravées par voie humide ou par voie sèche, sous l'action d'un agent réactif. La tendance actuelle s'oriente vers des techniques de gravure par voie sèche, notamment la gravure par plasma et, en particulier, la gravure que l'on appelle couramment RIE, acronyme provenant de l'anglais "Reactive Ion Etching". On rappelle qu'un plasma est un gaz porté à haute température, riche en ions et en électrons libres. Dans un réacteur de gravure par plasma, des décharges électroluminescentes sont formées à faible pression, et produisent des espèces chimiquement actives. Ces espèces se combinent à la surface d'une couche placée dans le réacteur pour y être gravée. Au cours d'une telle gravure, des composés volatils sont formés et évacués par un système de pompage.

A titre d'exemple, on réalise la gravure de l'aluminium par un plasma composé d'un gaz chloré tel que $BCl_3$, ledit agent réactif étant le chlore. Dans ce cas, la présence d'un gaz tel que $BCl_3$ est nécessaire pour éliminer l'oxyde natif en surface, cet oxyde n'étant pas attaqué par du chlore pur.

Dans la présente description, on associe à un procédé de gravure une vitesse de gravure que l'on peut définir comme le rapport de l'épaisseur moyenne gravée sur le temps de gravure nécessaire pour réaliser cette gravure.

Dans le domaine de la microélectronique, on utilise des couches polycristallines, par exemple pour réaliser des contacts électriques. A titre d'exemple, les matériaux communément utilisés pour former de telles couches comprennent l'aluminium, le silicium ou les siliciures. On rappelle qu'un siliciure est un composé à base de silicium et de matériaux réfractaires tels que le tungstène, le titane ou le molybdène.

De façon générale, une couche polycristalline est constituée d'une mosaïque de cristaux, c'est-à-dire de réseaux périodiques caractérisés par une maille élémentaire, dans lesquels il existe un nombre minimal de défauts cristallographiques tels que des ruptures de périodicité et des impuretés résiduelles. On rappelle que trois catégories d'espèces chimiques sont à considérer dans un matériau semiconducteur : les impuretés résiduelles tels que l'oxygène et le carbone dans le silicium, les impuretés de dopage et, éventuellement, les impuretés introduites volontairement, par exemple lors d'une hydrogénation de film de silicium polycristallin.

Pour définir une couche polycristalline, on parle également de "grains" accolés le long de lignes de contact appelées "joints de grain". Autrement dit, un joint de grain est une interface entre deux matériaux identiques mais désorientés l'un par rapport à l'autre.

A priori, on aurait tendance à penser que, dans des conditions de formation bien définies, la taille de grain d'une couche polycristalline est répartie de façon aléatoire. Toutefois, sachant que la croissance de cette couche correspond aux conditions thermodynamiques donnant lieu à un phénomène de nucléation autour d'un noyau critique, la taille maximale d'un grain est atteinte, lorsque le grossissement autour d'un noyau critique est arrêté par la présence d'un grain voisin. Par conséquent, dans la mesure où la distribution des noyaux critiques est homogène, celle de la taille de grain d'une couche polycristalline formée par nucléation autour de ces noyaux l'est également. Ainsi les tailles de ces grains se regroupent autour d'une valeur moyenne, avec une très faible dispersion.

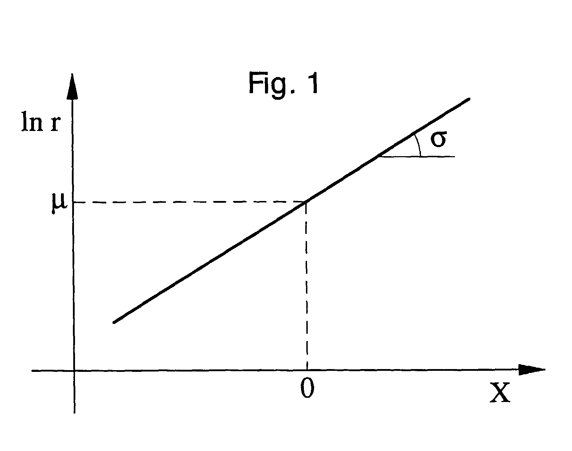

On peut ainsi modéliser la taille de ces grains par une distribution dite "log-normale", cette distribution étant largement décrite dans la littérature relative à la théorie de la probabilité. La figure 1 représente une courbe typique illustrant la distribution "log-normale" d'une grandeur telle que la taille de grain désignée r d'une couche polycristalline. Dans ce cas, cette courbe illustre la relation linéaire entre le logarithme népérien de la taille de grain r et la valeur normalisée correspondante désignée X, cette normalisation étant caractéristique de la distribution "log-normale". On peut ainsi définir une valeur moyenne désignée $\mu$ égale au logarithme népérien de la taille de grain r pour une valeur normalisée nulle, et une dispersion désignée $\sigma$ égale au coefficient de linéarité de cette relation, comme le représente la figure 1.

La demanderesse de la présente invention a noté que la structure d'une couche polycristalline n'est pas prise en compte lors de la gravure de cette couche. Autrement dit, on tient compte communément des caractéristiques macroscopiques de la couche à graver, par exemple son épaisseur.

Dans le domaine fortement compétitif de la microélectronique, l'une des principales préoccupations réside dans une recherche permanente pour diminuer le temps de fabrication des circuits intégrés, et augmenter le rendement des installations techniques mises en jeu lors d'une telle fabrication.

Un objet de la présente invention est de prévoir une méthode d'optimisation des procédés de dépôt et de gravure mis en oeuvre lors de la fabrication de circuits intégrés, cette méthode étant propre à augmenter le rendement des équipements relatifs à la gravure.

Un autre objet de la présente invention est de prévoir de tels procédés répondant aux critères traditionnels en industrie de coût et de complexité.

Ces objets, ainsi que d'autres, sont atteints par la méthode d'optimisation selon la revendication 1.

Un avantage de déterminer les paramètres de dépôt dans la méthode d'optimisation selon la présente invention est de pouvoir former une couche polycristalline dont la densité de joints de grain est liée à une valeur optimale de la vitesse de gravure, ayant pour effet d'augmenter cette vitesse, ce qui se traduit par une augmentation du rendement des équipements relatifs à la gravure.

Ces objets, caractéristiques et avantages, ainsi que d'autres, de la présente invention apparaîtront plus clairement à la lecture de la description détaillée d'une mise en oeuvre préférée de la présente invention, donnée à titre d'exemple uniquement, en relation avec les figures jointes, parmi lesquelles :

- la figure 1 représente une courbe typique illustrant une distribution "log-normale";
- la figure 2a représente une vue de dessus d'une couche polycristalline composée d'aluminium, de silicium et de titane, cette couche ayant une faible densité de joints de grain;
- la figure 2b illustre la distribution "log-normale" de cette taille de la couche représentée en figure 2a, l'axe des abscisses représentant la normalisation de cette taille;
- la figure 3a représente une vue de dessus d'une couche polycristalline composée d'aluminium, de silicium et de titane, cette couche ayant une forte densité de joints de grain;
- la figure 3b illustre la distribution "log-normale" de cette taille de la couche représentée en figure 3a, l'axe des abscisses représentant la normalisation de cette taille; et
- la figure 4 représente la vitesse de gravure de couches polycristallines en fonction du paramètre de structure de ces couches, à partir de données issues d'expériences menées par la demanderesse de la présente invention, ainsi qu'une approche analytique de ces données.

La méthode d'optimisation selon la présente invention est destinée à optimiser des procédés de dépôt et de gravure comprenant des étapes consistant à déposer une couche polycristalline composée d'au moins deux espèces chimiques, cette couche étant constituée de grains et de joints de grains, et graver la couche polycristalline par un agent réactif destiné à réagir avec l'une des deux espèces chimiques.

En outre, cette méthode consiste à déterminer les paramètres de dépôt susceptibles de provoquer la formation d'une couche polycristalline ayant la densité de joints de grain liée à une valeur optimale de la vitesse de gravure, et prendre en compte ces paramètres lors de la mise en oeuvre de ces procédés.

En effet, l'existence de joints de grain dans une couche polycristalline entraîne notamment une ségrégation des espèces chimiques de cette couche. A titre d'exemple, après recuit thermique à 600 °C, une couche polycristalline en silicium a une concentration en oxygène plus élevée dans les joints de grain que dans les grains. La table I résume ci-dessous quelques espèces chimiques désignées A sujettes à se ségréger au sein de couches polycristallines comprenant majoritairement une seconde espèce chimique désignée B.

Table I

| A | B |
|---|---|
| H, C, O, Cu, P, B | Si |
| Sn | GaAs |
| Fe, Ni, Al, C, O, Ti, Cu, Mg | Si |
| $Ga_2O_3$, $As_2O_3$ | GaAs |
| Bi | ZnO |

On note dans la table I que l'aluminium et le silicium sont deux espèces sujettes à se ségréger, à l'instar de l'oxygène dans le silicium, comme cela a déjà été mentionné.

Par conséquent, ledit agent réactif relatif à la méthode d'optimisation selon la présente invention étant destiné à réagir avec l'une des deux espèces chimiques, la réaction est favorisée dans les zones où cette espèce est présente majoritairement, autrement dit dans les grains ou, le cas échéant, dans les joints de grain, ce qui relie la vitesse de gravure à la densité de joints de grain d'une couche polycristalline.

Ceci est particulièrement avantageux, puisqu'il permet d'augmenter la vitesse de gravure de la couche polycristalline, en fonction de la structure de cette couche.

A cet effet, la méthode d'optimisation selon la présente invention définit un paramètre de structure f représentant la densité de joints de grain de ladite couche polycristalline, ce paramètre étant égal à la longueur totale de joint de grain par unité de surface.

La demanderesse de la présente invention a observé que la taille de grain suit une distribution "log-normale" tel que décrit ci-dessus, et que l'on peut ainsi définir une valeur moyenne désignée μ et une dispersion désignée σ de la taille de grain, comme cela est décrit également ci-dessus. En conséquence, la demanderesse de la présente invention a démontré que le paramètre de structure f est une fonction de la valeur moyenne μ et de la dispersion σ de la taille de grain de la couche polycristalline, la valeur moyenne et la dispersion de la taille de grain étant celles définies de façon plus détaillée ci-dessus. Dans le cas où la taille de grain suit une distribution "log-normale", la fonction reliant le paramètre de structure, la valeur moyenne μ de la taille de grain de la couche, et sa dispersion σ est :

$$f = 4 \frac{\mu^2}{\mu^2 + \sigma^2}$$

Cette fonction permet ainsi, à partir de la valeur moyenne μ et de la dispersion σ de la taille de grain de la couche polycristalline, de déterminer la valeur du paramètre de structure f de cette couche.

Suite à des expériences, la demanderesse de la présente invention a observé que la valeur moyenne de la taille de grain de la couche polycristalline dépend de la température de substrat lors de la formation de cette couche, comme cela est largement connu dans la littérature. Il va de soi que d'autres paramètres de dépôt interviennent pour la définition de la structure de la couche à former, notamment ceux liés au substrat, par exemple la nature cristallographique du substrat et la préparation de sa surface. A cet effet, la demanderesse de la présente invention a observé également que l'un des paramètres de dépôt les plus critiques pour déterminer la structure d'une couche polycristalline à former est l'existence d'une interruption de la mise sous vide du substrat entre l'étape précédent le dépôt de cette couche et ce dépôt.

Dans le cas préféré où l'agent réactif est destiné à réagir avec l'espèce présente majoritairement dans la couche polycristalline, notamment dans ses grains, la demanderesse de la présente invention a observé que la vitesse de gravure v tend à décroître en fonction du paramètre de structure f. Autrement dit, on peut choisir les paramètres de dépôt de manière à pouvoir former une couche polycristalline ayant un paramètre de structure compris dans une plage prédéterminée. Comme cela va être illustré ci-après, la plage prédéterminée dépend de l'espèce présente majoritairement dans la couche polycristalline, ainsi que des équipements relatifs au dépôt et à la gravure.

A titre de variante de mise en oeuvre, on peut également considérer le cas où l'agent réactif est destiné à réagir avec une espèce chimique présente dans la couche polycristalline, et sujette à se ségréger vis-à-vis de l'espèce présente majoritairement dans cette couche, de telles espèces chimiques figurant dans la table I ci-dessus. Dans ce cas, cette espèce chimique est présente en plus grande quantité dans les joints de grain de la couche polycristalline que dans les grains. Il va de soi que, dans ce cas, la vitesse de gravure v tend à croître en fonction du paramètre de structure f. Autrement dit, on peut choisir les paramètres de dépôt de manière à pouvoir former une couche polycristalline ayant un paramètre de structure compris dans une plage prédéterminée.

A titre illustratif uniquement, on va décrire une mise en oeuvre d'une méthode d'optimisation selon la présente invention, cette mise en oeuvre ayant été réalisé expérimentalement par la demanderesse de la présente invention.

Considérons le cas où l'on souhaite déposer puis graver une couche polycristalline composée de 98,85 % d'aluminium, de 1 % de silicium et de 0,15 % de titane. Une telle couche est formée par pulvérisation cathodique, puis gravée sous un procédé du type RIE susmentionné. Dans cette couche polycristalline, l'aluminium est présent majoritairement dans les grains.

La méthode d'optimisation selon la présente invention consiste à déterminer les paramètres de dépôt susceptibles de provoquer la formation de cette couche polycristalline ayant une densité de joints de grain liée à une valeur optimale de la vitesse de gravure.

Dans ce cas préféré où l'agent réactif est destiné à réagir avec l'espèce présente majoritairement dans la couche polycristalline, comme cela a déjà été mentionné, la vitesse de gravure est optimale quand les paramètres de dépôt sont choisis dans une plage susceptible de rendre optimale la vitesse de gravure.

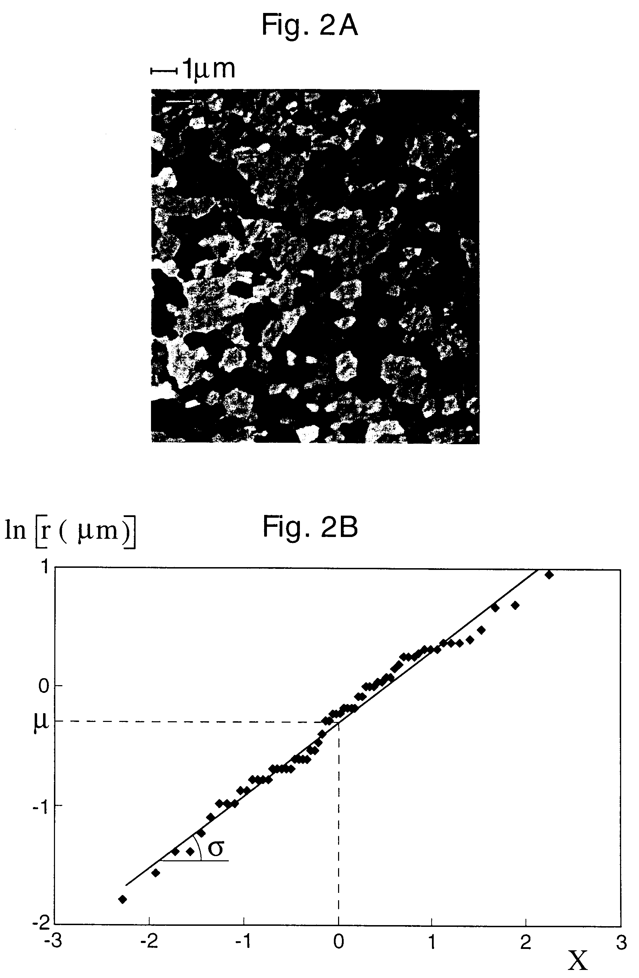

A cet effet, la demanderesse de la présente invention a formé par pulvérisation cathodique à 400 °C une couche polycristalline de AlSiTi tel que décrit ci-dessus, de manière à réaliser une telle couche ayant une faible densité de joints de grain. La figure 2a représente une vue de dessus d'une telle couche, cette vue ayant été réalisée avec un microscope de type FIB (acronyme communément utilisé et provenant de l'anglais "Focused Ion Beam"), sous un angle de 30 °.

Ensuite, la demanderesse de la présente invention a calculé la taille de grain de cette couche. A l'instar de la figure 1, la figure 2b illustre la distribution "log-normale" de cette taille désignée r de la couche représentée en figure 2a, l'axe des abscisses désignées X représentant la normalisation de cette taille. On peut ainsi définir une valeur moyenne désignée μ et une dispersion désignée σ, comme le représente la figure 1.

Il ressort de la figure 2a que la valeur moyenne μ et la dispersion σ de la taille de grain r sont égales à -0,308 et 0,602, respectivement. En utilisant la relation entre le paramètre de structure f, la valeur moyenne μ et la dispersion σ, on peut évaluer le paramètre de structure f pour cette couche. Il en ressort que ce paramètre est égal à 0,21.

Par la suite, la demanderesse de la présente invention a également évalué la vitesse de gravure désignée v lors de la gravure de cette couche sous le plasma du type susmentionné. Il en ressort que cette vitesse est de l'ordre de 490 nm/min.

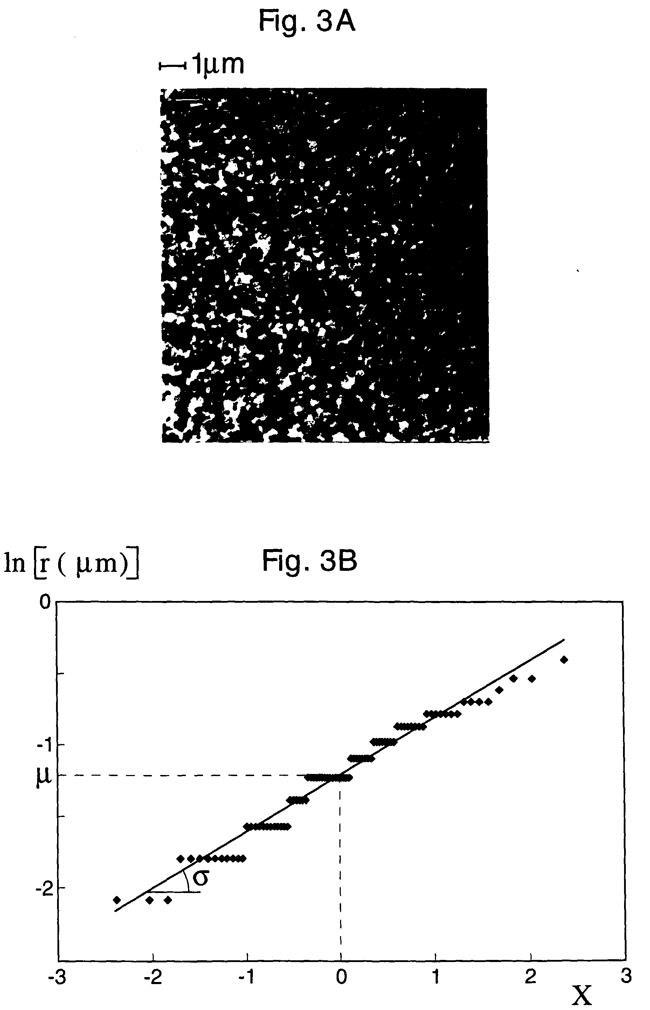

Par contre, la demanderesse de la présente invention a également formé par pulvérisation cathodique à 100 °C une couche polycristalline en AlSiTi du type susmentionné, de manière à réaliser une telle couche ayant une forte densité de joints de grain. La figure 3a représente une vue d'une telle couche, cette vue ayant été réalisée avec un microscope de type FIB, sous un angle de 30 °.

Ensuite, la demanderesse de la présente invention a calculé la taille de grain de cette couche. A l'instar de la figure 1, la figure 3b illustre la distribution "log-normale" de cette taille désignée r de la couche représentée en figure 3a, l'axe des abscisses désignées X représentant la normalisation de cette taille. On peut ainsi définir une valeur moyenne désignée $\mu$ et une dispersion désignée $\sigma$, comme le représente la figure 1.

Il ressort de la figure 3a que la valeur moyenne $\mu$ et la dispersion $\sigma$ de la taille de grain r sont égales à -1,22 et 0,394, respectivement. En utilisant la relation entre le paramètre de structure f, la valeur moyenne $\mu$ et la dispersion $\sigma$, on peut évaluer le paramètre de structure f pour cette couche. Il en ressort que ce paramètre est égal à 0,91.

Par la suite, la demanderesse de la présente invention a également évalué la vitesse de gravure désignée v lors de la gravure de cette couche sous le plasma du type susmentionné. Il en ressort que cette vitesse est de l'ordre de 450 nm/min.

On peut ainsi comparer la vitesse de gravure obtenue pour les deux couches représentées en figures 2a et 3a, et observer que la vitesse de gravure varie entre 490 nm/min et 450 nm/min, soit une variation de 8,8 %.

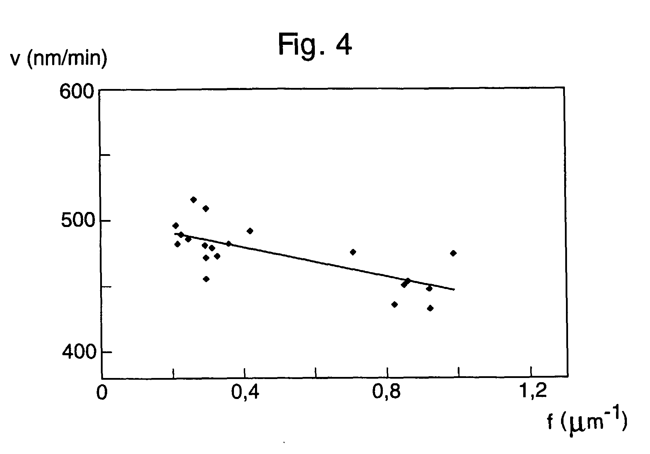

La figure 4 représente la vitesse de gravure v de couches polycristallines en fonction du paramètre de structure f de ces couches, à partir de données issues d'expériences menées par la demanderesse de la présente invention, ainsi qu'une approche analytique de ces données.

Les différents points expérimentaux représentés en figure 4 sont associés à diverses conditions de dépôt, les procédés de dépôt et de gravure étant semblables aux procédés décrits en relation avec les figures 2a et 3a.

On note en figure 4 que la vitesse de gravure tend à décroître avec le paramètre de structure f, et est optimale quand les paramètres de dépôt sont choisis de manière à pouvoir former une couche polycristalline ayant un paramètre de structure inférieur à 0,4.

Ces différents résultats sont conformes à ceux énoncés ci-dessus, dans le cas où l'agent réactif (ici le chlore) est destiné à réagir avec l'espèce chimique présente majoritairement dans la couche polycristalline (ici l'aluminium). En outre, dans ce cas, ladite plage prédéterminée comprend une limite supérieure de l'ordre de 0,4.

On peut également avancer diverses causes participant à la ségrégation dans une couche polycristalline en AlSiTi du type susmentionné. On notera ainsi que la solubilité du silicium dans l'aluminium croît avec la température, ce qui conduit pour des températures élevées à une accumulation du silicium dans les joints de grain de cette couche. On notera également que des impuretés résiduelles provenant du réacteur de dépôt s'accumulent dans les joints de grain.

De façon similaire, la demanderesse de la présente invention a également observé sur une couche polycristalline de TiW que la vitesse de gravure peut varier de 7,4 % suivant la structure de cette couche. En effet, des première et seconde couches polycristalline de TiW ont été déposées à 20 °C et 250 °C, respectivement. La demanderesse de la présente invention a ensuite évalué la vitesse de gravure à 94 nm/min et 101 nm/min, respectivement, ce qui représente une variation de 7,4 %.

Il va de soi pour l'homme de l'art que la description détaillée ci-dessus peut subir diverses modifications sans sortir du cadre de la présente invention.

**Revendications**

1. Méthode d'optimisation de procédés de dépôt et de gravure comprenant des étapes consistant à :

    - déposer une couche polycristalline composée d'au moins deux espèces chimiques, cette couche étant constituée de grains et de joints de grains; et
    - graver la couche polycristalline par un agent réactif destiné à réagir avec l'une des deux espèces chimiques,
    cette méthode étant caractérisée en ce qu'elle consiste a : déterminer les paramètres de dépôt susceptibles de provoquer la formation d'une couche polycristalline ayant la densité de joints de grain liée à une valeur optimale de la vitesse de gravure; et prendre en compte ces paramètres lors de la mise en oeuvre de ces procédés.

2. Méthode d'optimisation selon la revendication 1, caractérisée en ce qu'elle définit un paramètre de structure (f) représentant la densité de joints de grain de la couche polycristalline, ce paramètre étant égal à la longueur totale de joint de grain par unité de surface.

3. Méthode d'optimisation selon la revendication 2, caractérisée en ce qu'elle définit, au sens d'une distribution "log-normale" de la taille de grain de la couche polycristalline, une valeur moyenne ($\mu$) et une dispersion ($\sigma$) de cette taille, et en ce que le paramètre de structure est une fonction de cette valeur moyenne et de cette dispersion.

4. Méthode d'optimisation selon la revendication 3, caractérisée en ce que la fonction reliant le paramètre de structure (f), la valeur moyenne ($\mu$) de la taille de grain de la couche, et sa dispersion ($\sigma$) est :

$$f = 4\frac{\mu}{\mu^2+\sigma^2}$$

5. Méthode d'optimisation selon l'une des revendications 2 à 4, caractérisée en ce que l'un des paramètres de dépôt les plus critiques pour déterminer la structure de la couche polycristalline est la température de substrat lors de la formation de cette couche.

6. Méthode d'optimisation selon l'une des revendications 2 à 5, caractérisée en ce que l'agent réactif est destiné à réagir avec l'espèce présente majoritairement dans la couche polycristalline, et en ce que les paramètres de dépôt sont choisis de manière à pouvoir former une couche polycristalline ayant un paramètre de structure compris dans une plage prédéterminée.

7. Méthode d'optimisation selon la revendication 6, caractérisée en ce que la vitesse de gravure tend à décroître avec le paramètre de structure.

8. Méthode d'optimisation selon l'une des revendications 2 à 5, caractérisée en ce que l'agent réactif est destiné à réagir avec l'autre espèce chimique présente dans la couche polycristalline, cette espèce étant sujette à se ségréger vis-à-vis de l'espèce présente majoritairement dans cette couche, et en ce que les paramètres de dépôt sont choisis de manière à pouvoir former une couche polycristalline ayant un paramètre de structure compris dans une plage prédéterminée.

9. Méthode d'optimisation selon la revendication 8, caractérisée en ce que la vitesse de gravure tend à croître avec le paramètre de structure.

10. Méthode d'optimisation selon l'une quelconque des revendications 6 à 9, caractérisée en ce que la plage prédéterminée dépend de l'espèce présente majoritairement dans la couche polycristalline, ainsi que des équipements relatifs au dépôt et à la gravure.

Fig. 1

## Fig. 2A

## Fig. 2B

# Fig. 3A

⊢—1μm

# Fig. 3B

$\ln\left[\underline{r}\,(\,\mu m)\right]$

Fig. 4

EP 0 890 979 A1

**RAPPORT PARTIEL
DE RECHERCHE EUROPEENNE**

Office européen
des brevets

qui selon la règle 45 de la Convention sur le brevet
européen est consideré, aux fins de la procédure ultérieure
comme le rapport de la recherche européenne

Numéro de la demande

EP 97 11 1826

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 4 892 844 A (CHEUNG ROBIN W  ET AL)<br>* revendications 1-7 *<br>--- | | H01L21/3205<br>H01L21/285<br>H01L21/321<br>C23C14/58 |
| A | US 5 322 712 A (NORMAN JOHN A T  ET AL)<br>* colonne 4, ligne 62 - ligne 66 *<br>--- | | |
| A | US 5 344 793 A (ZEININGER HEINRICH  ET AL)<br>* colonne 1, ligne 25 - ligne 37 *<br>--- | | |
| A | US 4 561 907 A (RAICU BRUHA)<br>* colonne 1, ligne 66 - colonne 2, ligne 8 *<br><br>----- | | |

DOMAINES TECHNIQUES
RECHERCHES (Int.Cl.6)

H01L
C23C

## RECHERCHE INCOMPLETE

La division de la recherche estime que la présente demande debrevet européen n'est pas conforme aux dispositions de la Convention sur le brevet européen au point qu'une recherche significative sur l'état de la technique ne peut être effectuée au regard d'une partie des revendications.

Revendications ayant fait l'objet de recherches complètes:

Revendications ayant fait l'objet de recherches incomplètes:

Revendications n'ayant pas fait l'objet de recherches:

Raison pour la limitation de la recherche:

voir feuille supplémentaire C

| Lieu de la recherche | Date d'achèvement de la recherche | Examinateur |
|---|---|---|
| LA HAYE | 5 décembre 1997 | Königstein, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C08)

11

**Office européen**

**des brevets**

**RECHERCHE INCOMPLETE**
**FEUILLE SUPPLEMENTAIRE C**

Numéro de la demande

EP 97 11 1826

Revendications ayant fait
l'objet de recherches complètes:    0

Revendications ayant fait
l'objet de recherches incomplètes: 1-10

Raison pour la limitation de la recherche:

Les revendications sont énoncées de telle manière que leur objet est
défini par le resultat à obtenir. La formulation ici utilisée n'est pas
claire (Art. 84 CBE) et la description ne contient pas d'éléments
concrets pour mieux définir l'objet de la revendication.